# EUROPÄISCHE PATENTSCHRIFT

(11) **EP 2 795 657 B1**
(45) Veröffentlichungstag und Bekanntmachung des Hinweises auf die Patenterteilung: **12.12.2018**
(21) Anmeldenummer: 12775662.5
(22) Anmeldetag: 17.10.2012
(51) Int. Cl.: H01J 37/32

(54) **VORRICHTUNG ZUM ERZEUGEN EINES HOHLKATHODENBOGENENTLADUNGSPLASMAS**
DEVICE FOR PRODUCING A HOLLOW CATHODE ARC DISCHARGE PLASMA
DISPOSITIF POUR DÉCHARGE DE PLASMA AVEC UN CATHODE CREUSE

(30) Priorität: 19.12.2011 DE 102011121386
(43) Veröffentlichungstag der Anmeldung: 29.10.2014
(73) Patentinhaber: Fraunhofer-Gesellschaft zur Förderung der angewandten Forschung e.V., 80686 München (DE)
(72) Erfinder: MORGNER, Henry, 01257 Dresden (DE); MATTAUSCH, Gösta, 01454 Ullersdorf (DE); METZNER, Christoph, 01328 Dresden (DE); JUNGHÄHNEL, Michael, 01324 Dresden (DE); LABITZKE, Rainer, 01189 Dresden (DE); KLOSE, Lars, 01328 Dresden (DE); WERNER, Lars, 01219 Dresden (DE); KUBUSCH, Jörg, 01279 Dresden (DE)
(86) Internationale Anmeldenummer: PCT/EP2012/070535
(87) Internationale Veröffentlichungsnummer: WO 2013/091927

(56) Entgegenhaltungen:
- EP-A2- 1 094 130
- WO-A2-2009/022184
- DE-A1- 19 546 827
- DE-A1- 19 902 146

## Beschreibung

Die Erfindung betrifft eine Vorrichtung zum Erzeugen dichter Plasmen für Vakuumprozesse mittels mit wechselnder Polarität gepulster Hohlkathodenbogenentladungsquellen bei reaktiven oder nichtreaktiven Beschichtungsanwendungen. Die Vorrichtung ermöglicht neben dem Beschichten stationärer Substrate insbesondere auch das Beschichten bewegter bandförmiger Substrate. Die Vorrichtung ist für den Einsatz in Edelgas- und Reaktivgasatmosphären geeignet und damit auch für Oberflächenbehandlungen und für Plasma-Ätzprozesse einsetzbar. Wird in der nachfolgenden Erfindungsbeschreibung lediglich der Begriff Hohlkathode verwendet, so ist damit immer die Hohlkathode einer Hohlkathodenbogenentladungsquelle gemeint. Die Erfindung grenzt sich somit von Vorrichtungen ab, bei denen eine Hohlkathodenglimmentladungsquelle verwendet wird.

### Stand der Technik

Es ist bekannt, dass sich im Niederdruckbereich zwischen 10⁻² Pa und 1 Pa mit Hohlkathodenbogenentladungsplasmen sehr hohe Ladungsträgerdichten in der Größenordnung von 10¹² cm⁻³ erzielen lassen. Werden bei der Schichtabscheidung die schichtbildenden Partikel solch einem Plasma ausgesetzt, lassen sich vorteilhafte Schichteigenschaften erzielen.
Hierzu sind Vorrichtungen bekannt, bei denen sich der Dampf, insbesondere für größere Beschichtungsflächen und hohe Beschichtungsraten, effektiv aktivieren lässt, indem das Hohlkathodenplasma ausschließlich zur Plasmaaktivierung herangezogen wird. Die Plasmaentladungen dieser Vorrichtungen werden mit Gleichstrom betrieben. Die außer den Hohlkathoden zur Plasmagenerierung notwendigen Anoden sind bei derartigen Vorrichtungen teilweise mit der Verdampfungseinrichtung verkoppelt (DE 196 12 344 C1). Die Nutzung des Verdampfertiegels oder einer nahe am Verdampfertiegel angeordneten Elektrode als Anode hat den Nachteil, dass die Funktionsfähigkeit der Vorrichtungen auf eine mit der Verdampfung elektrisch leitfähiger Materialien verbundene Plasmaaktivierung beschränkt ist.

Es ist weiterhin bekannt, das Plasma mittels eines magnetischen Feldes zu führen. Wird durch geeignete magnetfelderzeugende Einrichtungen ein longitudinales Magnetfeld derart erzeugt, dass einige seiner Feldlinien von der Hohlkathode zur Anode führen, bleiben höherenergetische Strahlelektronen auf ihrem Weg von der Hohlkathode zur Anode im Bereich der verbindenden Feldlinien gebunden und halten das hochdichte Plasma in einem gewissen Abstand vom Substrat (DE 42 35 199 C1). Nachteilig ist dabei, dass durch das Fernhalten der höherenergetischen Strahlelektronen vom Substrat der Aufbau eines hohen Selbstbiaspotentials verhindert wird. Ein weiterer Nachteil besteht darin, dass die Anwendbarkeit auf spezielle Ausgestaltungen der Verdampfungseinrichtung mit aufwändigen Magnetsystemen beschränkt bleibt. Bei der Verdampfung isolierender Materialien ist zusätzlich ein erheblicher apparativer Aufwand für die Aufrechterhaltung der elektrischen Leitfähigkeit an der Anode erforderlich.

DE 195 46 827 A1 beschreibt eine Vorrichtung für das Verdampfen isolierender Materialien, bei der eine ringförmige Anode (eine sogenannte Ringanode) unmittelbar vor der Hohlkathode angeordnet ist, um das für die Plasmaaktivierung wirksame Plasma ausschließlich durch die Strahlelektronen zu erzeugen, welche die Öffnung der Ringanode durchdrungen haben. In diesem Fall scheiden sich keine störenden isolierenden Schichten auf der Ringanode ab, da sich diese im Wesentlichen außerhalb des Dampfbereiches befindet und die Ringanode durch die auftreffenden Strahlelektronen stark aufgeheizt wird. Da sich der Bereich der Plasmaaktivierung des Dampfes außerhalb des zwischen Hohlkathode und Anode aufgebauten elektrischen Feldes befindet, besteht jedoch der Nachteil, dass sich nur deutlich niedrigere Ladungsträgerdichten im Plasma erzeugen lassen, als mit Anordnungen, die den zu aktivierenden Bereich zwischen der Hohlkatode und der Anode einschließen. Darüber hinaus begrenzt die Reichweite der Strahlelektronen die geometrische Ausdehnung des Plasmas.

In DE 199 02 146 A1 wird vorgeschlagen, zwei aus der zuvor genannten Schrift bekannte Plasma erzeugende Einrichtungen, umfassend jeweils eine Hohlkathode mit zugehöriger Ringanode und dazwischen geschalteter Gleichspannungsquelle, gegenüberliegend anzuordnen und zwischen den zwei Hohlkathoden eine bipolar mittelfrequent gepulste Spannung zu erzeugen. Bei dieser Anordnung wird aufgrund der Gleichspannungsquelle zwischen Hohlkathode und Ringanode ständig ein Plasma zwischen der Hohlkathode und der zugehörigen Ringanode einer Plasma erzeugenden Einrichtung erzeugt. In den Phasen, in denen eine der beiden Plasma erzeugenden Einrichtungen aufgrund der bipolaren Spannungspulse kathodisch geschaltet ist, wird das Plasma der kathodisch geschalteten Plasma erzeugenden Einrichtung von deren Hohlkathode bis zur Ringanode der gegenüberliegenden Plasma erzeugenden Einrichtung gezogen. Auf diese Weise entsteht zwischen den beiden Ringanoden ein großvolumiges Hohlkathodenbogenentladungsplasma. Nachteilig wirkt sich bei diesem technisch anspruchsvollen Aufbau aus, dass viele Prozessparameter geregelt werden müssen, um gleichbleibende Plasmabedingungen zu erzielen.

### Aufgabenstellung

Der Erfindung liegt daher das technische Problem zugrunde, eine Vorrichtung zum Erzeugen eines Hohlkathodenbogenentladungsplasmas zu schaffen, mittels der die Nachteile des Standes der Technik überwunden werden können. Insbesondere soll mit der Vorrichtung sowohl ein Plasma mit hoher Intensität als auch ein Plasma mit großem Volumen erzeugbar sein. Die Vorrichtung soll sich ferner gegenüber dem Stand der Technik durch einen technisch vereinfachten Aufbau auszeichnen und auch bei Anwendungsfällen mit einem Umgebungsdruck von bis zu 100 Pa ein stabiles Plasma ausbilden.

Die Lösung des technischen Problems ergibt sich durch Gegenstände mit den Merkmalen des Patentanspruchs 1. Weitere vorteilhafte Ausgestaltungen der Erfindung ergeben sich aus den abhängigen Patentansprüchen.

Eine erfindungsgemäße Vorrichtung umfasst zwei Plasma erzeugende Einrichtungen, die gegenüberliegend angeordnet sind. Jede der beiden Plasma erzeugenden Einrichtungen besteht aus einer Hohlkathode, deren Rohr von einem Arbeitsgas durchströmt wird, und einer Elektrode, welche eine sich durch die Elektrode hindurch erstreckende Öffnung aufweist. Die Öffnung eines Kathodenrohres, aus welchem das Arbeitsgas herausströmt, wird nachfolgend als Austritts- oder Ausgangsöffnung der Hohlkathode bezeichnet.

Bei einer Ausführungsform ist die Elektrode vor der Austrittsöffnung der Hohlkathode angeordnet. Alternativ kann das Kathodenrohr mit der Seite seiner Austrittsöffnung aber auch in die Öffnung der zugehörigen Elektrode hineinragen oder auch vollständig durch die Öffnung der zugehörigen Elektrode hindurchragen. Dabei kann das durch die Öffnung der Elektrode hindurchragende Kathodenrohr mechanischen Kontakt mit der Elektrode aufweisen oder in einer alternativen Ausführungsform von der Elektrode beabstandet sein.

Vorzugsweise ist solch eine Elektrode als ringförmige Elektrode ausgebildet und derart angeordnet, dass die verlängerten Achsen des Hohlkathodenrohres und der Ringelektrode identisch sind.

Die Ausgangsöffnungen der beiden Hohlkathoden einer erfindungsgemäßen Vorrichtung sind einander zugewandt. Dabei können die beiden Plasma erzeugenden Einrichtungen (nachfolgend auch Plasmaquellen und in der Einzahl Plasmaquelle genannt) derart gegenüberliegend angeordnet sein, dass die verlängerten Rohrachsen der beiden Hohlkathodenrohre identisch sind. Alternativ können die Rohrachsen beider Hohlkathodenrohre auch einen Winkel zueinander aufweisen.

Zu einer erfindungsgemäßen Vorrichtung gehört ferner ein Pulsgenerator, der an beiden Hohlkathoden elektrisch angeschlossen ist und der zwischen den beiden Hohlkathoden eine bipolare mittelfrequent gepulste elektrische Spannung erzeugt. Die Pulse können dabei eine Frequenz in einem Bereich von 1 Hz bis 1 MHz aufweisen. Um einen Zerfall des zwischen den beiden Hohlkathoden erzeugten Plasmas beim Polaritätswechsel zu unterbinden, sollte der Polaritätswechsel mit einer Frequenz von mindestens 1 kHz vollzogen werden. Es hat sich daher als vorteilhaft erwiesen, wenn der Pulsgenerator mit einer Frequenz im Bereich von 1 kHz bis 100 kHz betrieben wird.

Im Stand der Technik weisen Plasma erzeugende Einrichtungen mit den bisher beschriebenen Merkmalen noch eine Gleichspannungsquelle auf, die zwischen der Hohlkathode und der vor der Hohlkathodenausgangsöffnung angeordneten Elektrode (im Stand der Technik als Anode ausgebildet) geschaltet ist. Diese Gleichspannungsquelle sorgt dafür, dass ständig ein Plasma zwischen Hohlkathode und der vor der Hohlkathode angeordneten Elektrode brennt.

Eine erfindungsgemäße Vorrichtung weist hingegen keine solche Gleichspannungsquelle zwischen einer Hohlkathode und der zugehörigen Elektrode auf. Stattdessen ist bei einer erfindungsgemäßen Vorrichtung die zu einer Plasma erzeugenden Einrichtung gehörende Hohlkathode elektrisch leitend mit der zugehörigen Elektrode verbunden.

Gezündet wird eine erfindungsgemäße Vorrichtung, indem mittels des Pulsgenerators Zündpulse bereitgestellt werden mit einer Zündspannung, die ein Mehrfaches der Brennspannung beträgt. Die Zündspannung kann dabei das 10-fache oder gar das 50-fache der Brennspannung betragen. Für das Zünden einer erfindungsgemäßen Vorrichtung können je nach Konfiguration der Vorrichtung Spannungen in einem Bereich von 100 V bis 5000 V erforderlich sein. Die bipolaren Zündspannungspulse des Pulsgenerators bewirken zunächst eine Glimmentladung zwischen den beiden Plasma erzeugenden Einrichtungen, infolge derer die beiden Hohlkathoden so lange erhitzt werden, bis die Glimmentladung in eine Hohlkathodenbogenentladung übergeht. Die Bogenentladung brennt dabei von der jeweils kathodisch geschalteten Hohlkathode vorwiegend zur Elektrode der gegenüberliegenden, anodisch geschalteten Plasmaquelle. Die anodischen Phasen einer Plasmaquelle sind auch der Grund, weshalb die Elektroden, die ja das gleiche elektrische Potenzial wie die zugehörige Hohlkathode aufweisen, benötigt werden. Die Oberfläche einer anodisch geschalteten Hohlkathode allein ist zu gering, um die Anzahl an Elektronen pro Zeiteinheit, die für die Aufrechterhaltung eines hohen Bogenstromes erforderlich sind, aus dem Plasma zu extrahieren. Die zu einer Plasmaquelle gehörende Elektrode dient somit lediglich zur Vergrößerung der Anodenoberfläche in den anodischen Phasen einer Plasma erzeugenden Einrichtung.

Wie oben schon einmal erwähnt, kann die Elektrode einer Plasma erzeugenden Einrichtung vor der Austrittsöffnung der zugehörigen Hohlkathode angeordnet sein, so dass sich die verlängerte Achse des Hohlkathodenrohres durch die Öffnung der Elektrode hindurch erstreckt. Da bei einer erfindungsgemäßen Vorrichtung die Elektrode im Wesentlichen nur zur Vergrößerung der Oberfläche in den anodischen Phasen beiträgt und keine Bogenentladung zwischen Hohlkathode und zugehöriger Elektrode brennt, kann sich bei einer alternativen Ausführungsform auch das Kathodenrohr selbst durch die Öffnung der Elektrode hindurch erstrecken. Dabei kann der Elektrodenring vom Kathodenrohr beabstandet sein oder auch mechanischen Kontakt mit dem Kathodenrohr aufweisen. Weist die Elektrode einen mechanischen Kontakt mit der Hohlkathode auf, entfällt die elektrisch verbindende Kontaktierung beider Bauelemente. Nachteilich wirkt sich hingegen aus, dass Wärmeenergie, welche zum Aufheizen der Hohlkathode benötigt wird, in das Elektrodenmaterial abgeleitet wird. Umgekehrt verhält es sich dementsprechend, wenn das sich durch die Öffnung der Elektrode erstreckende Hohlkathodenrohr von der Elektrode beabstandet ist. Dann wird weniger Wärmeenergie von der Hohlkathode in das Elektrodenmaterial abgeleitet, zusätzlich ist aber noch eine elektrisch verbindende Kontaktierung beider Bauelemente erforderlich.

Der Vollständigkeit halber sei noch erwähnt, dass nach dem Zünden einer Bogenentladung zwischen den beiden Plasma erzeugenden Einrichtungen die Spannung der vom Pulsgenerator erzeugten Pulse von der Höhe der Zündspannung auf eine aus dem Stand der Technik bekannte Brennspannung reduziert wird. Als Pulsgenerator, der sowohl in der Lage ist Zündspannungspulse als auch eine Brennspannung bereitzustellen, kann beispielsweise ein aus DE 10 2008 047 198 A1 bekannter Pulsgenerator verwendet werden.

Gerade in einer Zündphase, in der noch eine Glimmentladung zwischen den beiden Plasma erzeugenden Einrichtungen erzeugt wird und die beiden Hohlkathoden erst noch aufgeheizt werden müssen, wirkt es sich jedoch negativ aus, wenn Hohlkathode und zugehörige Elektrode das gleiche Spannungspotenzial aufweisen. In den kathodischen Phasen einer Plasmaquelle fließt der Kathodenstrom dann nicht nur über die Hohlkathode der kathodisch geschalteten Plasmaquelle, sondern auch über die zugehörige Elektrode. Der Hohlkathode steht somit nur ein verminderter Heizstrom zur Verfügung, wodurch das Aufheizen der Hohlkathode verzögert wird.
Es hat sich daher als vorteilhaft erwiesen, wenn zwischen einer Hohlkathode und der zugehörigen Elektrode ein stromrichtungsbegrenzendes Bauelement, wie beispielsweise eine Diode geschaltet wird. Dann weisen Hohlkathode und zugehörige Elektrode in den anodischen Phasen das gleiche Spannungspotenzial auf, wohingegen in den kathodischen Phasen aufgrund des Spannungsabfalls über das stromrichtungsbegrenzende Bauelement eine Spannungsdifferenz zwischen Hohlkathode und zugehöriger Elektrode besteht, wodurch der über die Hohlkathode fließende Heizstrom gegenüber einer Ausführungsform ohne stromrichtungsbegrenzendes Bauelement erhöht wird.
Wie schon zuvor erwähnt, sind zum Zünden einer erfindungsgemäßen Vorrichtung Zündpulse mit einer sehr hohen Spannung erforderlich. Die Höhe der Zündspannung kann verringert werden, wenn jede Plasma erzeugende Einrichtung von einer separaten Magnetspule umschlossen ist. Darunter ist zu verstehen, dass die Elektrode und zumindest ein Endbereich des Kathodenrohres mit der Ausgangsöffnung der zur Elektrode zugehörigen Hohlkathode von der Magnetspule umschlossen sind. Vorzugsweise ist solch eine Magnetspule ringförmig ausgebildet und rotationssymmetrisch um das Hohlkathodenrohr angeordnet.

Derartig ausgebildete Magnetspulen bewirken im Glimmentladungsmode eine Reduktion der Plasmaimpedanz, wodurch die Spannungshöhe der Pulse während der Zündphase verringert werden kann. Dabei besteht folgender Zusammenhang: Je höher die Magnetfeldstärke ist, umso geringere Spannungen sind für die Pulse in der Zündphase erforderlich. Umgekehrt gilt: Je höhere Spannungen verwendet werden, umso geringer kann die Magnetfeldstärke einer eine Plasmaquelle umschließenden Magnetspule gewählt werden. Welche Magnetfeldstärke bei einer vorgegebenen maximalen Spannungspulshöhe bzw. welche Spannungspulshöhe bei einer vorgegebenen maximalen Magnetfeldstärke zum sicheren Zünden einer Bogenentladung erforderlich sind, ist abhängig von einer jeweiligen Anlagenkonfiguration, lässt sich jedoch mit einfachen Laborversuchen ermitteln.
Die beiden Magnetspulen können bezüglich ihrer Polarität derart angeordnet sein, dass deren Magnetfeldlinien in gleichem Richtungssinn verlaufen. Bei dieser Ausführungsform entsteht in einem zentralen Bereich zwischen den beiden Hohlkathoden ein Plasma mit einer sehr hohen Intensität. Insbesondere beim Zünden einer erfindungsgemäßen Vorrichtung sollten die Magnetfelder der beiden Magnetspulen den gleichen Richtungssinn aufweisen, weil dadurch das Zünden der Vorrichtung erleichtert wird.
Bei einer alternativen Ausführungsform sind die beiden Magnetspulen bezüglich ihrer Polarität derart angeordnet, dass deren Magnetfeldlinien einen entgegengesetzten Richtungssinn aufweisen. Die sich bei dieser Ausführungsform überlagernden Magnetfelder beider Plasma erzeugenden Einrichtungen führen zu einem Gesamtmagnetfeld, das ein Plasma mit größerem Volumen zwischen den Hohlkathoden erzeugt, welches jedoch eine niedrigere Intensität aufweist als das Plasma der zuvor beschriebenen Ausführungsform bei ansonsten gleichbleibenden Anlagenparametern.
Aus DE 10 2006 027 853 A1 ist eine auf einer Hohlkathode basierenden Plasmaquelle bekannt, bei der nach dem Zünden einer Bogenentladung die Flussmenge des durch die Hohlkathode strömenden Arbeitsgases so weit reduziert wird, bis eine Zunahme der Plasmaintensität zu verzeichnen ist. Auch eine erfindungsgemäße Vorrichtung kann mit dieser Vorgehensweise betrieben werden, wodurch ein Plasma mit noch höherer Intensität ausgebildet wird.

### Ausführungsbeispiel

Die Erfindung wird nachfolgend anhand von Ausführungsbeispielen näher erläutert. Die Fig. zeigen:
- Fig. 1: eine schematische Darstellung einer erfindungsgemäßen Vorrichtung;
- Fig. 2: eine schematische Darstellung einer alternativen Vorrichtung;
- Fig. 3: eine schematische Darstellung einer weiteren alternativen erfindungsgemäßen Vorrichtung;
- Fig. 4: eine schematische Darstellung einer Anlage zum Vakuumbedampfen eines Substrates mit integrierter erfindungsgemäßer Vorrichtung.

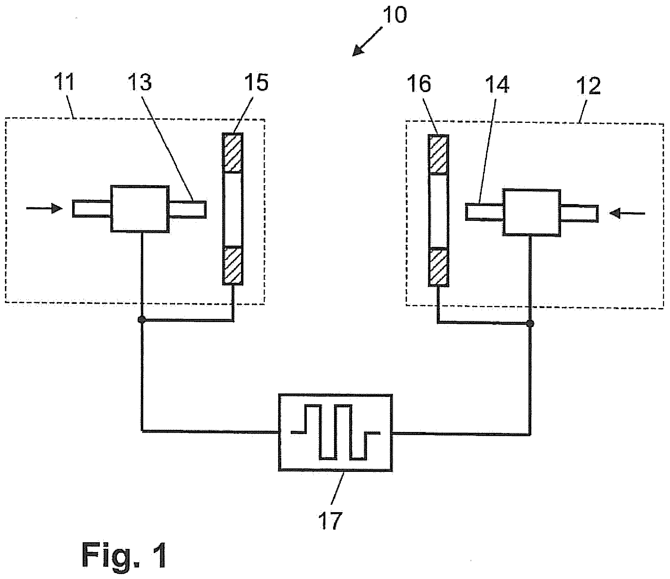

In Fig. 1 ist eine erfindungsgemäße Vorrichtung 10 schematisch dargestellt. Vorrichtung 10 umfasst zwei Plasma erzeugende Einrichtungen 11 und 12, die jeweils aus einer Hohlkathode 13, 14 und einer zugehörigen Elektrode 15, 16 bestehen. Beide Elektroden 15, 16 sind ringförmig ausgebildet und vor der Austrittsöffnung der jeweils zugehörigen Hohlkathode 13, 14 derart angeordnet, dass die verlängerten Achsen des Hohlkathodenrohres und des Elektrodenringes identisch sind. Die Pfeile hinter den Hohlkathoden 13, 14 geben die Durchflussrichtung an, in der ein Arbeitsgas das Rohr einer jeweiligen Hohlkathode 13, 14 durchströmt.

Bei der Plasmaquelle 11 sind die Hohlkathode 13 und die Elektrode 15 miteinander elektrisch leitend verbunden so wie in der Plasmaquelle 12 die Hohlkathode 14 mit der zugehörigen Elektrode 16 elektrisch leitend verbunden ist. Ein Pulsgenerator 17 ist mit den beiden Hohlkathoden 15, 16 elektrisch verbunden und erzeugt zwischen den beiden Plasmaquellen 11, 12 eine bipolar gepulste Spannung mit einer Frequenz von 10 kHz.
In der Zündphase der Vorrichtung 10 werden mittels des Pulsgenerators 17 Spannungspulse von bis zu 1800 V erzeugt. Infolgedessen entsteht zunächst eine Glimmentladung zwischen den beiden Plasmaquellen 11 und 12. Der dabei durch die Hohlkathoden 13 und 14 fließende elektrische Strom erhitzt die Hohlkathoden 13, 14 bis zu einer Elektronen-Emissionstemperatur, bei der die Glimmentladung zur Bogenentladung übergeht und somit ein Hohlkathodenbogenentladungsplasma zwischen den Plasmaquellen 11 und 12 ausgebildet wird. Ab diesem Zeitpunkt werden die vom Pulsgenerator 17 erzeugten Pulse auf eine Brennspannung von etwa 60 V abgesenkt. Dabei brennt die Bogenentladung in den Phasen, in denen die Plasmaquelle 11 kathodisch geschaltet ist, im Wesentlichen von der Hohlkathode 13 zur Elektrode 16. In den Phasen, in denen die Plasmaquelle 12 kathodisch geschaltet ist, brennt die Bogenentladung im Wesentlichen von der Hohlkathode 14 zur Elektrode 15. Aufgrund dessen, dass bei einer erfindungsgemäßen Vorrichtung eine Bogenentladung immer zwischen der Hohlkathode einer Plasmaquelle und der Elektrode einer gegenüberliegenden Plasmaquelle brennt, bewirkt die als Anode geschaltete Elektrode der gegenüberliegenden Plasmaquelle eine Nachbeschleunigung der Elektronen im Plasma, was sich insbesondere bei Anwendungsfällen mit erhöhtem Umgebungsdruck (bis 100 Pa)vorteilhaft auswirkt, weil sich bei hohem Druck die mittleren freien Weglängen der Elektronen stark verkürzen.

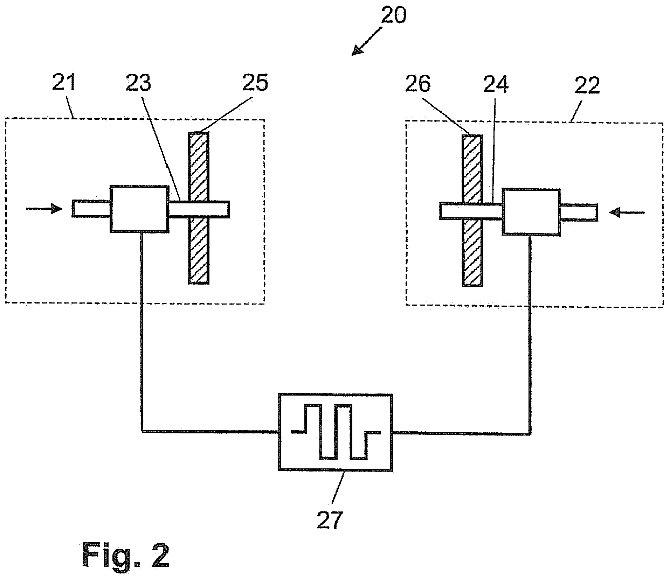

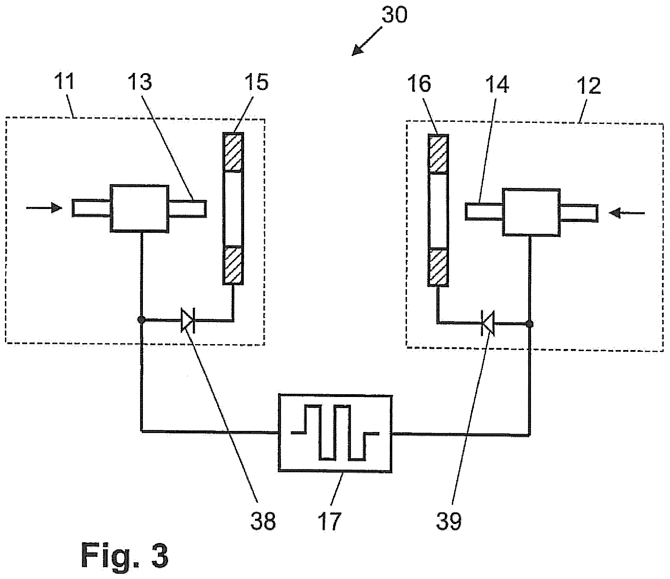

In Fig. 2 ist eine alternative Vorrichtung 20 schematisch dargestellt. Vorrichtung 20 umfasst zwei Plasma erzeugende Einrichtungen 21 und 22, die jeweils aus einer Hohlkathode 23, 24 und einer zugehörigen Elektrode 25, 26 bestehen. Beide Elektroden 25, 26 sind ringförmig ausgebildet und auf dem Rohr der jeweils zugehörigen Hohlkathode 23, 24 befestigt. Hohlkathode und zugehörige Elektrode weisen dadurch einen mechanischen Kontakt auf und benötigen keine zusätzliche elektrische Kontaktierung. Die Pfeile hinter den Hohlkathoden 23, 24 geben auch hier die Durchflussrichtung an, in der ein Arbeitsgas das Rohr einer jeweiligen Hohlkathode 23, 24 durchströmt.
Ein Pulsgenerator 27 ist mit den beiden Hohlkathoden 25, 26 verbunden und erzeugt zwischen den beiden Plasmaquellen 21, 22 eine bipolar gepulste Spannung. Die Parameter und Handhabung des Pulsgenerators 27 zum Zünden und Aufrechterhalten einer Bogenentladung zwischen den beiden Plasmaquellen 21, 22 sind identisch mit den entsprechenden Parametern des Pulsgenerators 17 aus Fig. 1. Auch bei diesem Ausführungsbeispiel brennt eine Bogenentladung zwischen der Hohlkathode einer Plasmaquelle und der Elektrode der anderen Plasmaquelle.
Eine weitere alternative Ausführungsform einer erfindungsgemäßen Vorrichtung 30 ist in Fig. 3 schematisch dargestellt. Vorrichtung 30 gleicht der in Fig. 1 dargestellten Vorrichtung 10 bis auf ein technisches Detail. In Fig. 3 umfassen die beiden Plasma erzeugenden Einrichtungen 11 und 12 zusätzlich noch jeweils eine Diode 38 bzw. 39, die zwischen der Hohlkathode und der zugehörigen Elektrode einer jeweiligen Plasmaquelle geschaltet ist. Die Dioden 38 und 39 bewirken in den kathodischen Phasen einer Plasmaquelle einen Spannungsabfall und bewirken somit, dass die Hohlkathode und die zugehörige Elektrode der kathodisch geschalteten Plasmaquelle ein unterschiedliches elektrisches Potential aufweisen. Infolgedessen erhöht sich der über die Hohlkathode fließende Kathodenstrom, wodurch die Kathode besser mittels Stromdurchfluss erhitzt wird als ohne zwischengeschaltete Diode. Dies macht sich insbesondere durch ein verkürztes Zünden der Vorrichtung 30 gegenüber der in Fig. 1 dargestellten Vorrichtung 10 bemerkbar.

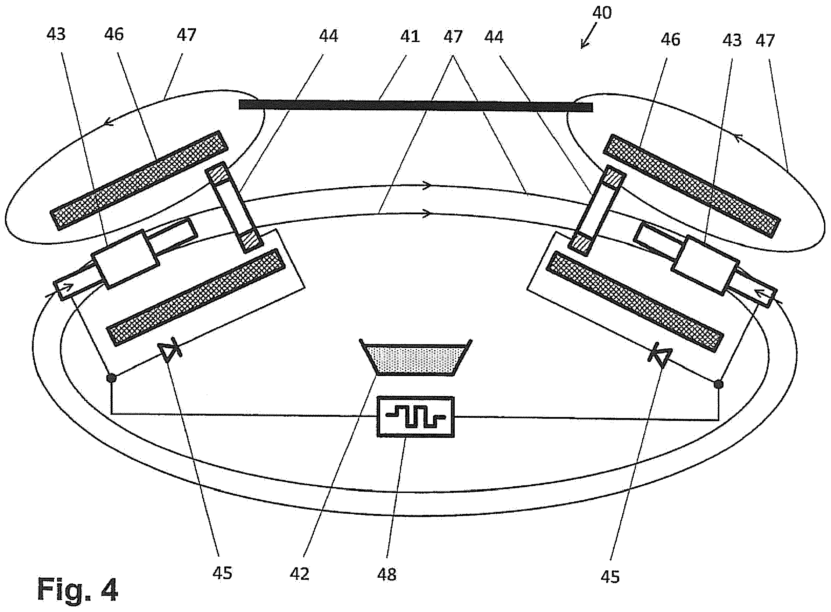

In Fig. 4 ist eine unter Vakuumbedingungen arbeitende Anlage 40 dargestellt, mittels der eine Seite eines bandförmigen Substrates 41 bedampft werden soll. Dazu wird sich in einem Gefäß 42 befindendes Material derart erhitzt, dass das Material verdampft und sich der aufsteigende Materialdampf auf der dem Gefäß 42 zugewandten Seite des Substrates 41 niederschlägt. Zum Erzielen gewünschter Schichteigenschaften ist es erforderlich, dass der aufsteigende Materialdampf von einem Plasma hoher Intensität durchdrungen wird. Zum Erzeugen dieses Plasmas wurde eine erfindungsgemäße Vorrichtung in die Anlage 40 integriert.

Die erfindungsgemäße Vorrichtung umfasst zwei identische, gegenüberliegend angeordnete Plasma erzeugende Einrichtungen, die jeweils eine Hohlkathode 43, eine vor der Hohlkathode 43 angeordnete ringförmige Elektrode 44 und eine zwischen Hohlkathode 43 und Elektrode 44 geschaltete Diode 45 als Bestandteile aufweisen. Zusätzlich zu den zuvor in den Fig. 1 bis 3 dargestellten Ausführungsformen gehört zu jeder der in Fig. 4 dargestellten Plasmaquellen auch noch eine Magnetspule 46, welche die Hohlkathode 43 und die zugehörige Elektrode 44 einer Plasmaquelle rotationssymmetrisch umschließt. Die verlängerten Achsen von Hohlkathode 43, Elektrode 44 und Magnetspule 46 einer Plasmaquelle sind demzufolge identisch. Diese Achse wird nachfolgend auch als Achse einer Plasmaquelle bezeichnet.

Die beiden Magnetspulen 46 werden gleichsinnig erregt und erzeugen ein magnetisches Führungsfeld 47. Dieses geht mit wachsender Entfernung von den Hohlkatoden 43 in ein magnetisches Streufeld über. Der obere Teil der Feldlinien führt zum Substrat 41. Die Achsen der beiden in Fig. 4 gegenüberliegend dargestellten Plasmaquellen weisen einen Winkel zueinander auf. Dabei sind die Hohlkatoden 43 so ausgerichtet, dass der gerichtete Anteil der Plasmaelektronen durch das magnetische Führungsfeld 47 teilweise zum Substrat 41 hin und teilweise nahe am Substrat 41 vorbei zur Ringelektrode 44 der gegenüberliegenden Plasmaquelle hin geführt wird. Der Teil der gerichteten Elektronen, welcher auf das Substrat 41 trifft, erzeugt auf isolierenden Oberflächen eine hohe negative Selbstbiasspannung, welche den kondensierenden Ionen durch die Beschleunigung in der Plasmarandschicht zusätzliche Energie verleiht. Die Gestaltung des Magnetfeldes führt zu einem Feldstärkegradienten vom Bereich der geschlossenen Feldlinien zum Substrat 41 hin. Dieser Gradient bewirkt ebenfalls eine Beschleunigung der Ionen aus dem Plasma, was zu einer erhöhten Ionenstromdichte am Substrat 41 und zu einem weiteren Zuwachs der Ionenenergie führt.

Ein zwischen den beiden Hohlkathoden 43 geschalteter Pulsgenerator 48 erzeugt sowohl die bipolaren Pulse für das Zünden der Bogenentladungen zwischen den beiden Plasmaquellen als auch die bipolaren Pulse in der Spannungshöhe der Brennspannung. Wie die Pulsgeneratoren bei allen Ausführungsformen erfindungsgemäßer Vorrichtungen können auch mit Pulsgenerator 48 sowohl symmetrische als auch unsymmetrische bipolare Pulse mit variablem Tastverhältnis zur Anwendung gelangen.

Die in Fig. 4 dargestellte Form von Plasmaquellen einer erfindungsgemäßen Vorrichtung, umfassend eine Hohlkathode, eine davor angeordnete Ringelektrode, ein zwischen Hohlkathode und Ringelektrode geschaltetes stromrichtungsbegrenzendes Bauelement und eine rotationssymmetrisch um Hohlkathode und Ringelektrode angeordnete Magnetspule, stellt eine bevorzugte Ausführungsform dar. Dieser Aufbau ist gegenüber dem Stand der Technik, bei dem eine Gleichspannungsquelle zwischen Hohlkathode und dortiger Anode geschaltet ist, technisch einfacher realisierbar und durch den Wegfall der Gleichspannungsquelle müssen auch weniger Parameter geregelt werden. Ferner lässt sich eine Bogenentladung zwischen den Plasmaquellen dieser Ausführungsform schnell und zuverlässig zünden. In Abhängigkeit von der Polarität der gegenüberliegenden Magnetspulen lassen sich des Weiteren sowohl ein volumenbezogen konzentriertes Plasma hoher Intensität als auch ein großvolumiges Plasma erzeugen.

## Patentansprüche

1. Vorrichtung zum Erzeugen eines Hohlkathodenbogenentladungsplasmas, bestehend aus zwei Plasmaquellen (11; 12), umfassend jeweils eine Hohlkathode (13; 14) und eine zur Hohlkathode (13; 14) zugehörige Elektrode (15; 16) mit einer sich durch die Elektrode (15; 16) hindurch erstreckenden Öffnung, wobei die Hohlkathoden (13; 14) beider Plasmaquellen (11; 12) an einen Pulsgenerator (17) angeschlossen sind, der zwischen den beiden Hohlkathoden (13; 14) eine bipolar mittelfrequent gepulste Spannung erzeugt, **dadurch gekennzeichnet, dass** bei beiden Plasmaquellen (11; 12) die Hohlkathode (13; 14) direkt oder ausschließlich unter Zwischenschaltung mindestens eines stromrichtungsbegrenzenden Bauelements (38; 39) elektrisch leitend mit der zugehörigen Elektrode (15; 16) verbunden ist.

2. Vorrichtung nach Anspruch 1, **dadurch gekennzeichnet, dass** die Elektrode (15; 16) vor der Austrittsöffnung der zugehörigen Hohlkathode (13; 14) angeordnet ist.

3. Vorrichtung nach Anspruch 1, **dadurch gekennzeichnet, dass** das Rohr der Hohlkathode (23; 24) durch die Öffnung der zugehörigen Elektrode (25; 26) hindurchragt.

4. Vorrichtung nach Anspruch 3, **dadurch gekennzeichnet, dass** die Hohlkathode (23; 24) einen mechanischen Kontakt mit der Elektrode (25; 26) aufweist.

5. Vorrichtung nach einem der vorhergehenden Ansprüche, **dadurch gekennzeichnet, dass** die Elektrode (15; 16) ringförmig ausgebildet ist.

6. Vorrichtung nach Anspruch 5, **dadurch gekennzeichnet, dass** die verlängerten Achsen der Hohlkathode (13; 14) und der ringförmigen Elektrode (15; 16) identisch sind.

7. Vorrichtung nach einem der vorhergehenden Ansprüche, **dadurch gekennzeichnet, dass** jede Plasmaquelle eine separate Magnetspule (46) aufweist, welche die Hohlkathode (43) und die zugehörige Elektrode (44) umschließt.

8. Vorrichtung nach Anspruch 7, **dadurch gekennzeichnet, dass** die Magnetspule (46) ringförmig ausgebildet ist.

9. Vorrichtung nach Anspruch 8, **dadurch gekennzeichnet, dass** die verlängerten Achsen der ringförmigen Magnetspule (46) und des Rohres der Hohlkathode (43) identisch sind.

10. Vorrichtung nach einem der vorhergehenden Ansprüche, **dadurch gekennzeichnet, dass** die bipolar mittelfrequent gepulste Spannung eine Frequenz im Bereich von 1 Hz bis 1 MHz aufweist.

11. Vorrichtung nach Anspruch 10, **dadurch gekennzeichnet, dass** die bipolar mittelfrequent gepulste Spannung eine Frequenz im Bereich von 1 kHz bis 100 kHz aufweist.

12. Vorrichtung nach einem der vorhergehenden Ansprüche, **dadurch gekennzeichnet, dass** das stromrichtungsbegrenzende Bauelement eine Diode ist.

## Claims

1. Device for producing a hollow cathode arc discharge plasma, consisting of two plasma sources (11; 12), each comprising a hollow cathode (13; 14) and an electrode (15; 16) which is associated with the hollow cathode (13; 14) and has an opening extending through the electrode (15; 16), wherein the hollow cathodes (13; 14) of the two plasma sources (11; 12) are connected to a pulse generator (17) which generates a bipolar, medium-frequency pulsed voltage between the two hollow cathodes (13; 14), **characterized in that** in both plasma sources (11; 12) the hollow cathode (13; 14) is connected in an electrically conductive manner to the associated electrode (15; 16) directly or only with the interconnection of at least one current-direction limiting component (38; 39).

2. Device according to Claim 1, **characterized in that** the electrode (15; 16) is arranged before the outlet opening of the associated hollow cathode (13; 14).

3. Device according to Claim 1, **characterized in that** the tube of the hollow cathode (23; 24) protrudes through the opening of the associated electrode (25; 26) .

4. Device according to Claim 3, **characterized in that** the hollow cathode (23; 24) is in mechanical contact with the electrode (25; 26).

5. Device according to one of the preceding claims, **characterized in that** the electrode (15; 16) has a ring-shaped form.

6. Device according to Claim 5, **characterized in that** the extended axes of the hollow cathode (13; 14) and of the ring-shaped electrode (15; 16) are identical.

7. Device according to one of the preceding claims, **characterized in that** each plasma source has a separate magnetic coil (46), which encloses the hollow cathode (43) and the associated electrode (44) .

8. Device according to Claim 7, **characterized in that** the magnetic coil (46) has a ring-shaped form.

9. Device according to Claim 8, **characterized in that** the extended axes of the ring-shaped magnetic coil (46) and of the tube of the hollow cathode (43) are identical.

10. Device according to one of the preceding claims, **characterized in that** the bipolar, medium-frequency pulsed voltage has a frequency in the range from 1 Hz to 1 MHz.

11. Device according to Claim 10, **characterized in that** the bipolar, medium-frequency pulsed voltage has a frequency in the range from 1 kHz to 100 kHz.

12. Device according to one of the preceding claims, **characterized in that** the current-direction limiting component is a diode.

## Revendications

1. Dispositif pour générer un plasma de décharge en arc de cathode creuse, composé de deux sources de plasma (11 ; 12), comportant chacune une cathode creuse (13 ; 14) et une électrode (15 ; 16) associée à la cathode creuse (13 ; 14), avec une ouverture qui s'étend à travers l'électrode (15 ; 16), les cathodes creuses (13 ; 14) des deux sources de plasma (11 ; 12) étant raccordées à un générateur d'impulsions (17) qui génère entre les deux cathodes creuses (13 ; 14) une tension pulsée bipolaire à moyenne fréquence, **caractérisé en ce que** sur les deux sources de plasma (11 ; 12), la cathode creuse (13 ; 14) est reliée de manière électriquement conductrice à l'électrode (15 ; 16) associée directement ou exclusivement en interconnectant au moins un composant (38 ; 39) de limitation du sens du courant.

2. Dispositif selon la revendication 1, **caractérisé en ce que** l'électrode (15 ; 16) est disposée devant l'ouverture de sortie de la cathode creuse (13 ; 14) associée.

3. Dispositif selon la revendication 1, **caractérisé en ce que** le tube de la cathode creuse (23 ; 24) fait saillie à travers l'ouverture de l'électrode (25 ; 26) associée.

4. Dispositif selon la revendication 3, **caractérisé en ce que** la cathode creuse (23 ; 24) possède un contact mécanique avec l'électrode (25 ; 26).

5. Dispositif selon l'une des revendications précédentes, **caractérisé en ce que** l'électrode (15 ; 16) est de configuration annulaire.

6. Dispositif selon la revendication 5, **caractérisé en ce que** les axes prolongés de la cathode creuse (13 ; 14) et de l'électrode (15 ; 16) annulaire sont identiques.

7. Dispositif selon l'une des revendications précédentes, **caractérisé en ce que** chaque source de plasma possède une bobine magnétique (46) séparée qui entoure la cathode creuse (43) et l'électrode (44) associée.

8. Dispositif selon la revendication 7, **caractérisé en ce que** la bobine magnétique (46) est de configuration annulaire.

9. Dispositif selon la revendication 8, **caractérisé en ce que** les axes prolongés de la bobine magnétique (46) annulaire et du tube de la cathode creuse (43) sont identiques.

10. Dispositif selon l'une des revendications précédentes, **caractérisé en ce que** la tension pulsée bipolaire à moyenne fréquence possède une fréquence dans la plage de 1 Hz à 1 MHz.

11. Dispositif selon la revendication 10, **caractérisé en ce que** la tension pulsée bipolaire à moyenne fréquence possède une fréquence dans la plage de 1 kHz à 100 kHz.

12. Dispositif selon l'une des revendications précédentes, **caractérisé en ce que** le composant de limitation du sens du courant est une diode.
